# EUROPEAN PATENT APPLICATION

(11) **EP 2 270 855 A1**
(43) Date of publication of application: **05.01.2011**
(21) Application number: 09164030.0
(22) Date of filing: 29.06.2009
(51) Int. Cl.: H01L 25/07, H01L 25/18, H01L 21/60, H01L 23/538

(54) **An electrical module**

(71) Applicant: ABB Research Ltd., 8050 Zürich (CH)
(72) Inventor: Haederli, Christoph, 00380 Helsinki (FI); Liu, Chunlei, 00380 Helsinki (FI); Kicin, Slavo, 00380 Helsinki (FI); Agostini, Bruno, 00380 Helsinki (FI); Wildner, Franz, 00380 Helsinki (FI)
(74) Representative: Brax, Matti Juhani

(57) **Abstract**

A method for fabricating an electrical module comprising a first substrate plate (101), a second substrate plate (102), and semiconductor components (103-110) between the first and second substrate plates is presented. Also an electrical module obtainable with the method and an electrical converter device including such electrical modules are presented. In the method, a bond (112) between first sides of the semiconductor components and the first substrate plate is made by sintering and, subsequently, a bond (111) between second sides of the semiconductor components and the second substrate plate is made by soldering. As the sintered bond can withstand high temperatures, a high temperature solder can be used for the soldered bond without damaging the earlier made sintered bond.

## Description

### Field of the invention

The invention relates to an electrical module that comprises two substrate plates and one or more semiconductor components between the substrate plates. Furthermore, the invention relates to a method for fabricating an electrical module of the kind mentioned above. Furthermore, the invention relates to an electrical converter device.

### Background

A double-side cooled electrical module is an attractive concept for a power device since it allows applying higher currents compared to one-side cooled electrical modules at the same operating temperature. One of the possible designs of the double-side cooled module is an electrical module where the electrical terminals of semiconductor components such as e.g. insulated gate bipolar transistors (IGBT) and diodes are directly bonded between electrically and thermally conductive substrate plates. These substrate plates have also a function of the thermal and electrical contacts to heat sinks of the relevant power system. Hence, the substrate plates and the heat sinks constitute a part of the main current circuitry of the power system. One of the critical issues of the fabrication process of such an electrical module is bonding of the semiconductor components to the substrate plates since properties of these bonds may limit operating temperature and reliability of the electrical module.

Usually a double-side cooled electrical module of the kind described above is fabricated using two subsequent soldering steps. In the first soldering step, high temperature solder is used for bonding the semiconductor components to one of the substrate plates and, in the second soldering step, lower temperature solder is used for bonding the semiconductor components to the other substrate plate. The lower temperature solder is used in the second step in order avoid damaging the soldered bonds made in the first step. One of the factors determining an upper limit for operating temperature of the electrical module is the melting temperature of the lower temperature solder that is used in the second soldering step. Furthermore, when a double-side cooled electrical module has been installed into the relevant power system, the double-side cooled electrical module is pressed between elements of the power system and pressure thus applied to the substrate plates can cause squeezing out of the solder if the operating temperature of the electrical module rises too close to the melting temperature of the lower temperature bond. Limits given by the squeezing out of the solder and the solder melting temperature can be shifted up by making the above-mentioned bonds of the electrical module in a single soldering step using high temperature solder for the bonding. However, this requires a relatively complex alignment of parts of the electrical module, which can be in many cases inconvenient, technically demanding, and expensive.

### Summary

In accordance with the first aspect of the invention, there is provided a new method for fabricating an electrical module comprising a first substrate plate, a second substrate plate, and one or more semiconductor components between the first and second substrate plates. The method according to the invention comprises:
- bonding first sides of the one or more semiconductor components to the first substrate plate by sintering, and subsequently
- bonding the second substrate plate to second sides of the one or more semiconductor components by soldering.

As the sintered bond can withstand high temperatures, high temperature solder can be used in the subsequent soldering step. With certain sintered materials it is possible to obtain a melting temperature near to 1000 °C. Hence, the operating temperature of an electrical module fabricated with the process described above can be higher than that of an electrical module which is fabricated using successive soldering steps with high and low temperature solder materials. For example, micrometer or even nanometer-scale silver powder can be used in the sintering process not demanding pressures and temperatures which could harm the semiconductor components. Soldering is a suitable process for the second bonding step because it allows compensate a possible tilt of the semiconductor components and possible differences between heights of surfaces of the semiconductor components caused by tolerances of the sintering process and tolerances of the thickness of the semiconductor components. Control terminals of semiconductor components, e.g. a gate of an insulated gate bipolar transistor, can be bonded with a suitable technique in a separate step if necessary.

In accordance with the second aspect of the invention, there is provided a new electrical module. The electrical module comprises:
- a first substrate plate,
- a second substrate plate, and
- one or more semiconductor components between the first and second substrate plates,
wherein a bond between the one or more semiconductor components and the first substrate plate is a sintered bond and a bond between the one or more semiconductor components and the second substrate plate being a soldered bond.

In accordance with the third aspect of the invention, there is provided a new electrical converter device. The electrical converter device comprises at least one an electrical module according to the invention, and the first and second substrate plates of the electrical module constitute a part of the main current circuitry of the electrical converter device. The electrical converter device can be, e.g. an inverter, a rectifier, and/or a frequency converter.

A number of exemplifying embodiments of the invention are described in accompanied dependent claims.

Various embodiments of the invention both as to constructions and to methods of operation, together with additional objects and advantages thereof, will be best understood from the following description of specific exemplifying embodiments when read in connection with the accompanying drawings.

The verb "to comprise" is used in this document as an open limitation that neither excludes nor requires the existence of also unrecited features. The features recited in depending claims are mutually freely combinable unless otherwise explicitly stated.

### Brief description of the figures

The exemplifying embodiments of the invention and their advantages are explained in greater detail below in the sense of examples and with reference to the accompanying drawings, in which:
figure 1 a shows a side view of an electrical module according to an embodiment of the invention,
figure 1b shows a section view of the electrical module shown in figure 1a, the section being taken along the line A-A of figure 1 a,
figure 2a shows an electrical converter device according to an embodiment of the invention,
figure 2b shows a detail of the electrical converter device shown in figure 2a, and
figure 3 is a flow chart of a method according to an embodiment of the invention for fabricating an electrical module.

### Description of the embodiments

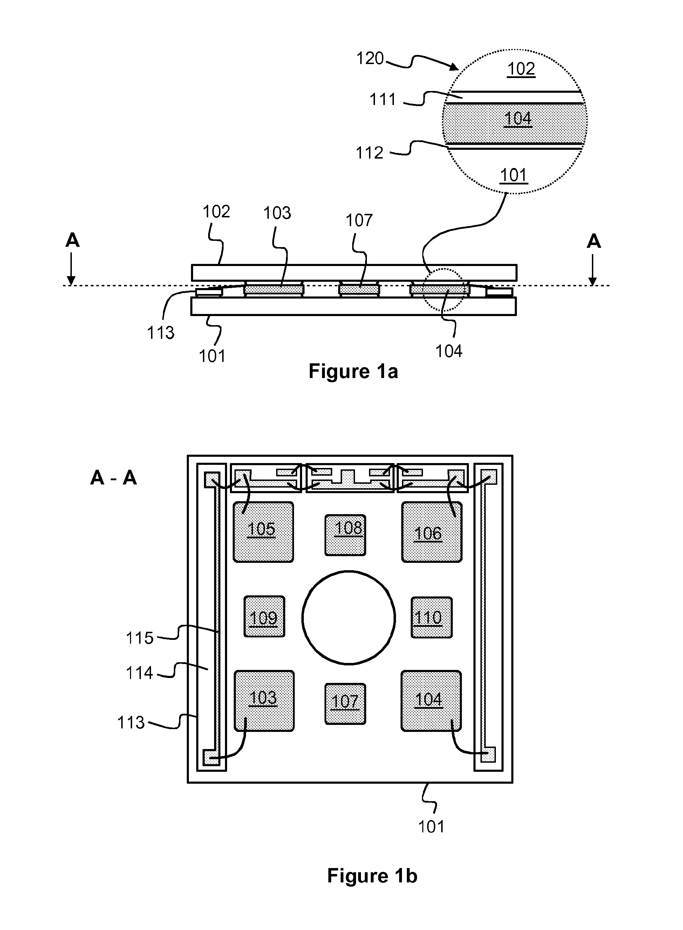

Figure 1 a shows a side view of an electrical module according to an embodiment of the invention and figure 1b shows a section view A-A of the electrical module shown in figure 1a. The electrical module comprises a first substrate plate 101, a second substrate plate 102, and one or more semiconductor components 103, 104, 105, 106, 107, 108, 109, and 110 between the substrate plates 101 and 102. The substrate plates 101 and 102 are made of copper, aluminum, molybdenum, metal-matrix composite, or other electrically and thermally conductive material. They can be coated to make the surface suitable for the selected bonding process. The substrate plates form together with heat sinks a part of a main current path when the electrical module is in use. Each of the semiconductor components 103-110 can be, for example but not necessarily, one of the following: an insulated gate bipolar transistor (IGBT), a field effect transistor (FET), a gate turn-off thyristor (GTO), a thyristor, or a diode. For example, it is possible that the semiconductor components 103-106 are insulated gate bipolar transistors (IGBT) and the semiconductor components 107-110 are diodes that are anti-parallel to the IGBTs.

Bonds between the semiconductor components and the substrate plate 101 are sintered bonds, and bonds between the semiconductor components and the substrate plate 102 are soldered bonds. A partial magnification 120 shows a sintered bond 112 between the substrate plate 101 and the semiconductor component 104 and a soldered bond 111 between the substrate plate 102 and the semiconductor component 104. As the sintered bonds can withstand high temperatures, it is possible to make the soldered bonds with a high temperature solder after making the sintered bonds. With certain sintered materials it is possible to obtain a melting point near to even 1000 °C. For example, micrometer or nanometer-scale silver powder can be used for the sintering. Hence, the operating temperature of the electrical module shown in figures 1 a and 1 b can be higher than that of an electrical module in which the corresponding bonds are made in successive soldering steps using first a high temperature solder and then a low temperature solder.

An electrical module according to an exemplifying embodiment of the invention comprises one or more wiring structures for control signals of the semiconductor components. Each wiring structure 113 comprises an insulator layer 114 and a metal strip 115 on the insulator layer. The metal strip can be e.g. of copper or aluminum. The wiring structures are bonded to the same side of the substrate plate 101 as the semiconductor components. The wiring structures are preferably DCB substrates (Direct Copper Bonding) as they withstand temperatures above 300 °C and are thus advantageous from the viewpoint of fabrication of the electrical module. The DCB substrates can be bonded to the substrate plate 101 either by sintering or by soldering. If the sintering is used, the DCB substrates are bonded to the substrate plate 101 preferably in conjunction with the same fabrication step when the semiconductor components are bonded to the substrate plate 101 by sintering. Whereas if the soldering is used, the DCB substrates are bonded to the substrate plate 101 preferably in conjunction with the same fabrication step when the semiconductor components are bonded to the substrate plate 102 by soldering.

For another example, the wiring structures can be PCBs (Printed Circuit Board) that are attached to the to the substrate plate 101 with adhesives after the substrate plates 101 and 102 have been bonded to the semiconductor components. The attachment of the PCBs may require certain special tools and/or arrangements due to the fact that the gap between the substrate plates 101 and 102 may be relatively narrow. For example, wire bonding can be used to connect the gate contacts on the semiconductor components and the wiring structures.

In an electrical module according to an embodiment of the invention, the one or more semiconductor components comprise one or more an insulated gate bipolar transistors (IGBT). A collector side of each insulated gate bipolar transistor is bonded to the substrate plate 101 and an emitter side of each insulated gate bipolar transistor is bonded to the substrate plate 102. The one or more semiconductor components may further comprise one or more diodes that are anti-parallel to the IGBTs.

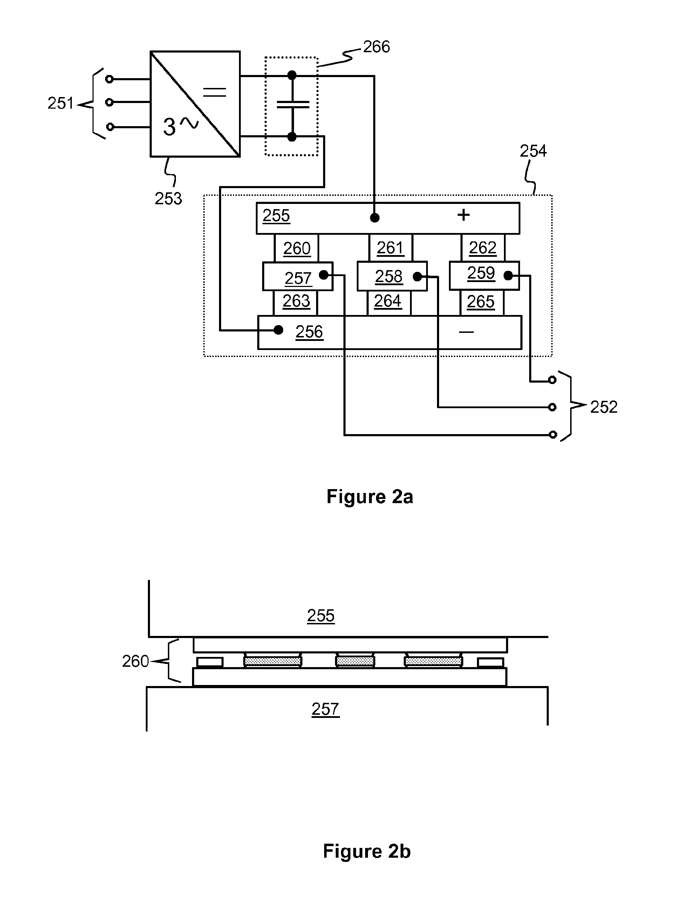

An electrical converter device according to an embodiment of the invention comprises at least one an electrical module according to an embodiment of the invention. Figure 2a shows an electrical converter device according to an embodiment of the invention. The electrical converter device comprises an electrical terminal 251 for connecting the electrical converter device to an alternating voltage network (not shown) and an electrical terminal 252 for connecting the electrical converter device to a load (not shown) that can be e.g. an induction motor. The electrical converter device comprises a converter unit 253 that can be e.g. a rectifier that is arranged to transfer energy from the alternating voltage network to an intermediate circuit 266 of the electrical converter device. The converter unit 253 can be as well a device that is capable of transferring energy not only from the alternating voltage network to the intermediate circuit 266 but also from the intermediate circuit back to the alternating voltage network.

The electrical converter device comprises an inverter bridge 254 that is able to transfer energy from the intermediate circuit 266 to the load and also to transfer energy from the load to the intermediate circuit. The main circuit of the inverter bridge comprises electrical conductor elements 255 and 256 that are connected to the intermediate circuit, and electrical conductor elements 257, 258, and 259 that are connected to different phases of the electrical terminal 252. The main circuit of the inverter bridge comprises electrical modules 260, 261, 262, 263, 264, and 265 that are pressed between the electrical conductor elements 255-259 as shown in figure 2a. Each of the electrical modules 260-265 comprises:
- a first substrate plate,
- a second substrate plate, and
- one or more semiconductor components between the first and second substrate plates,
wherein a bond between the one or more semiconductor components and the first substrate plate is a sintered bond and a bond between the one or more semiconductor components and the second substrate plate is a soldered bond.

The electrical modules 260-265 can be, for example, according to what is described in figures 1 a and 1 b and in the text passages related to figures 1 a and 1 b. The outer surfaces of the first and second substrate plates of the electrical modules 260-265 are pressed towards the electrical conductor elements 255-259 as illustrated in figure 2b for the electrical module 260. As can be seen from figures 2a and 2b, the first and second substrate plates of the electrical modules 260-265 constitute a part of the main current circuitry of the electrical converter device. The semiconductor components of each of the electrical modules 260-265 may comprise, for example, one or more an insulated gate bipolar transistors (IGBT) and one or more diodes that are anti-parallel to the IGBTs.

The electrical converter device shown in figure 2a is a frequency converter. An electrical converter device according to an embodiment of the invention can be as well, for example but not necessarily, a mere inverter or a mere rectifier.

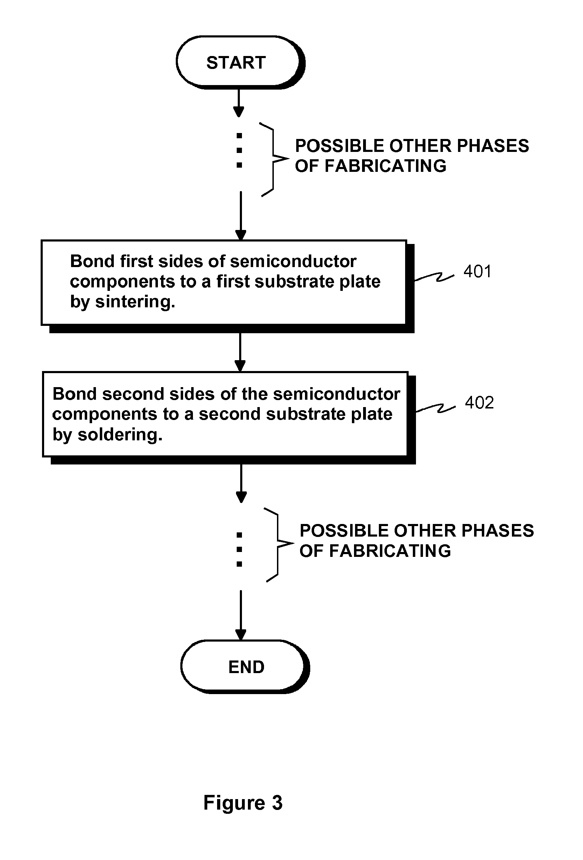

Figure 3 is a flow chart of a method according to an embodiment of the invention for fabricating an electrical module comprising a first substrate plate, a second substrate plate, and one or more semiconductor components between the first and second substrate plates. The method comprises:
- bonding in a method step 401 first sides of the one or more semiconductor components to the first substrate plate by sintering, and subsequently
- bonding in a method step 402 the second substrate plate to second sides of the one or more semiconductor components by soldering.

In a method according to an embodiment of the invention, micrometer or nanometer-scale silver powder is used for the sintering.

A method according to a more advanced embodiment of the invention comprises bonding one or more wiring structures for control signals of the one or more semiconductor components to the same side of the first substrate plate as the one or more semiconductor components. Each of the wiring structures comprises an insulator layer and a metal strip on one or both sides of the insulator layer.

In a method according to an embodiment of the invention, the one or more wiring structures are bonded to the first substrate plate by sintering in conjunction with the same method step 401 when the first sides of the one or more semiconductor components are bonded to the first substrate plate by sintering.

In a method according to an embodiment of the invention, the one or more wiring structures are bonded to the first substrate plate by soldering in conjunction with the same method step 402 when the second substrate plate is bonded to second sides of the one or more semiconductor components by soldering.

In a method according to an embodiment of the invention, each of the semiconductor components is one of the following: an insulated gate bipolar transistor (IGBT), a field effect transistor (FET), a gate turn-off thyristor (GTO), a thyristor, a diode.

In a method according to an embodiment of the invention, the one or more semiconductor components comprise one or more an insulated gate bipolar transistors (IGBT), wherein a collector side of each insulated gate bipolar transistor is bonded to the first substrate plate and an emitter side of each insulated gate bipolar transistor is bonded to the second substrate plate. The one or more semiconductor components may further comprise one or more diodes that are oriented to be anti-parallel to the IGBTs.

The specific examples provided in the description given above should not be construed as limiting. Therefore, the invention is not limited merely to the embodiments described above, many variants being possible.

## Claims

1. An electrical module comprising a first substrate plate (101), a second substrate plate (102), and one or more semiconductor components (103-110) between the first and second substrate plates, a bond (111) between the one or more semiconductor components and the second substrate plate being a soldered bond, **characterized in that** a bond (112) between the one or more semiconductor components and the first substrate plate is a sintered bond.

2. An electrical module according to claim 1, wherein the electrical module further comprises one or more wiring structures (113) for control signals of the one or more semiconductor components, each of the wiring structures comprising an insulator layer (114) and a metal strip (115) on one or both sides of the insulator layer and being bonded to the same side of the first substrate plate as the one or more semiconductor components.

3. An electrical module according to claim 2, wherein the bond between the wiring structure and the first substrate plate is a sintered bond.

4. An electrical module according to claim 2, wherein the bond between the wiring structure and the first substrate plate is a soldered bond.

5. An electrical module according to claim 1, wherein each of the semiconductor components is one of the following: an insulated gate bipolar transistor (IGBT), a field effect transistor (FET), a gate turn-off thyristor (GTO), a thyristor, a diode.

6. An electrical module according to claim 1, wherein the sintered bond is of micrometer or nanometer-scale silver powder.

7. An electrical module according to claim 1, wherein the one or more semiconductor components comprise one or more an insulated gate bipolar transistors (IGBT) and a collector side of each insulated gate bipolar transistor is bonded to the first substrate plate and an emitter side of each insulated gate bipolar transistor is bonded to the second substrate plate.

8. An electrical converter device, **characterized in that** the electrical converter device comprises at least one electrical module (260-265) according to claim 1, and the first and second substrate plates of the electrical module constitute a part of a main current circuitry of the electrical converter device.

9. A method for fabricating an electrical module comprising a first substrate plate, a second substrate plate, and one or more semiconductor components between the first and second substrate plates, **characterized in that** the method comprises:
- bonding (401) first sides of the one or more semiconductor components to the first substrate plate by sintering, and subsequently
- bonding (402) the second substrate plate to second sides of the one or more semiconductor components by soldering.

10. A method according to claim 9, wherein the method further comprises bonding one or more wiring structures for control signals of the one or more semiconductor components to the same side of the first substrate plate as the one or more semiconductor components, each of the wiring structures comprising an insulator layer and a metal strip on one or both sides of the insulator layer.

11. A method according to claim 10, wherein the one or more wiring structures are bonded to the first substrate plate by sintering in conjunction with the same method step when the first sides of the one or more semiconductor components are bonded to the first substrate plate by sintering.

12. A method according to claim 10, wherein the one or more wiring structures are bonded to the first substrate plate by soldering in conjunction with the same method step when the second substrate plate is bonded to second sides of the one or more semiconductor components by soldering.

13. A method according to claim 9, wherein each of the semiconductor components is one of the following: an insulated gate bipolar transistor (IGBT), a field effect transistor (FET), a gate turn-off thyristor (GTO), a thyristor, a diode.

14. A method according to claim 9, wherein micrometer or nanometer-scale silver powder is used for the sintering.

15. A method according to claim 9, wherein the one or more semiconductor components comprise one or more an insulated gate bipolar transistors (IGBT) and a collector side of each insulated gate bipolar transistor is bonded to the first substrate plate and an emitter side of each insulated gate bipolar transistor is bonded to the second substrate plate.
